# DEMANDE DE BREVET EUROPEEN

(11) **EP 1 575 098 A1**
(43) Date de publication de la demande: **14.09.2005**
(21) Numéro de dépôt: 05101839.8
(22) Date de dépôt: 09.03.2005
(51) Int. Cl.: H01L 29/93, H01L 21/329, H01L 21/02

(54) **Condensateur intégré**

(30) Priorité: 10.03.2004 FR 0450483
(71) Demandeur: ST MICROELECTRONICS S.A., 92120 Montrouge (FR)
(72) Inventeur: Sautreuil, Bernard, 38120, Saint Egrève (FR); Marty, Michel, 38760, Saint Paul de Varces (FR); Bonnouvrier, Jérôme, 38000, Grenoble (FR); Carpentier, Jean-François, 38100, Grenoble (FR)
(74) Mandataire: de Beaumont, Michel

(57) **Abrégé**

L'invention concerne un condensateur réalisé dans une partie supérieure d'un substrat semiconducteur (20), comprenant au moins une couche semiconductrice (24) faiblement dopée de type N dont la surface supérieure comporte une région fortement dopée de type P (35) délimitée par une zone d'isolement (34), un contact du condensateur étant constitué d'une couche métallique (44) enterrée immédiatement sous la couche semiconductrice de type N et d'au moins un contact métallique vertical traversant la couche semiconductrice jusqu'à la couche métallique, le contact atteignant la surface de la couche semiconductrice en dehors de la région de type P.

## Description

La présente invention concerne une structure et un procédé de fabrication d'un condensateur intégré dans un substrat semiconducteur. Plus particulièrement, la présente invention concerne un tel condensateur dont la capacité varie en fonction de la tension appliquée à ses bornes.

Des condensateurs à capacité variable sont classiquement réalisés sous la forme d'une jonction PN dont la zone de charge d'espace constitue un isolant d'épaisseur variable. En pratique, on ajuste la valeur nominale recherchée de la capacité en formant plusieurs jonctions PN. Pour ce faire, on réalise généralement une cathode commune sous la forme d'une couche semiconductrice de type N dans laquelle sont formées plusieurs régions d'anode de type P.

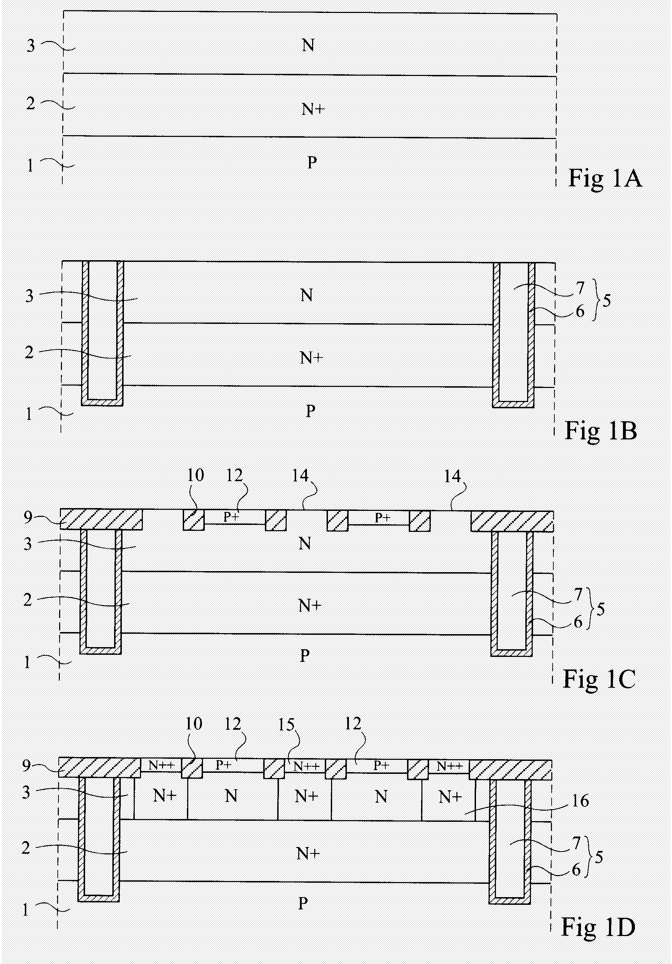

Les figures 1A à 1D illustrent des vues en coupe partielle et schématique de différentes étapes de formation d'un tel condensateur selon un procédé connu.

Comme l'illustre la figure 1A, le procédé part d'un substrat de silicium monocristallin 1, par exemple faiblement dopé de type P. On commence par former du côté de la face supérieure du substrat successivement une couche (N⁺) 2 de silicium monocristallin très fortement dopée de type N et une couche supérieure (N) 3 de silicium monocristallin dopée de type N.

Aux étapes suivantes, illustrées en figure 1B, on forme dans les couches 3 et 2 et une portion du substrat 1 une zone d'isolement profonde 5. La zone d'isolement 5 est une tranchée dont les parois et le fond sont recouverts d'une couche mince d'oxyde de silicium 6, la cavité restante étant remplie de silicium polycristallin 7. Dans la suite de la description, on ne considérera plus que les étapes mises en oeuvre dans la portion interne définie par la zone d'isolement 5.

Ensuite, comme l'illustre la figure 1C, on forme dans la seule couche 3 des zones d'isolement peu profondes du type tranchées remplies d'oxyde de silicium. Plus particulièrement, on forme une zone périphérique 9 qui s'étend de part et d'autre de la zone d'isolement profonde 5. On forme également, à l'intérieur de la portion de la couche 3 définie par la zone profonde 5, des zones d'isolement 10 de faibles dimensions qui permettent de définir des régions distinctes à la surface de la couche 3. On forme ensuite des régions fortement dopées de type P (P⁺) 12. Les régions 12 sont formées de façon que chaque région 12 soit délimitée par une zone d'isolement 10. Une portion 14 de la couche 3 est maintenue entre deux zones 10 périphériques à des régions 12 distinctes. Une portion 14 est également maintenue entre la zone périphérique 9 et les zones d'isolement 10.

Ensuite, comme l'illustre la figure 1D, on procède à des implantations de dopants de type N de façon à former, à la surface des portions 14, des régions (N⁺⁺) 15 très fortement dopées de type N et, entre ces régions 15 et la couche enterrée 2, des régions verticales 16 fortement dopées de type N.

Le procédé se poursuit ensuite par la formation de métallisations non représentées de contact d'anode et de cathode solidaires des régions 12 et 15, respectivement.

Les dimensions et les niveaux de dopage des différentes couches et régions de la figure 1D sont typiquement les suivantes :
couche 2 : 100 à 200 nm, dopage de type N compris entre 10¹⁹ at./cm³ et 10²⁰ at./cm³ ;
couche 3 : 100 à 200 nm, dopage de type N compris entre 10¹⁵ et 10¹⁸ at./cm³ ;
régions 12 et 15 : d'une profondeur sensiblement égale à celle des zones d'isolement 10, de l'ordre de 20 à 50 nm, dopées respectivement de type P et N de l'ordre de 10²⁰ à 10²¹ at./cm³ ; et
régions verticales 16 : dopées de type N de l'ordre de 10¹⁷ à 10¹⁸ at./cm³.

Un inconvénient du condensateur obtenu à l'aide du procédé décrit précédemment réside dans la résistance élevée d'accès à la cathode. En effet, en excluant la métallisation dont la résistance est égale à celle de la métallisation d'anode, le contact de cathode est constitué de la succession de la région de surface 15, d'une région verticale 16 et de la couche enterrée 2. Ainsi, en considérant les caractéristiques de dimension et de dopage précédentes, la résistance d'accès à la cathode est de l'ordre de 70 à 80 Ω.

Un objet de la présente invention est par conséquent de proposer un condensateur intégré à résistance de cathode réduite.

Un autre objet de la présente invention est de proposer un tel condensateur sans accroître la résistance d'anode.

La présente invention vise également à proposer un procédé de fabrication d'un tel condensateur.

Pour atteindre ces objets, la présente invention prévoit un condensateur réalisé dans une partie supérieure d'un substrat semiconducteur, comprenant au moins une couche semiconductrice faiblement dopée de type N dont la surface supérieure comporte une région fortement dopée de type P délimitée par une zone d'isolement, un contact du condensateur étant constitué d'une couche métallique enterrée immédiatement sous la couche semiconductrice de type N et d'au moins un contact métallique vertical traversant la couche semiconductrice jusqu'à la couche métallique, le contact atteignant la surface de la couche semiconductrice en dehors de la région de type P.

Selon un mode de réalisation de la présente invention, la couche métallique et le contact métallique sont constitués d'un même matériau métallique choisi dans le groupe comprenant le tungstène, le nitrure de titane, le titane, le cuivre et des alliages de ces matériaux.

La présente invention prévoit également un procédé de formation d'un condensateur du type comprenant, dans une partie supérieure d'un substrat semiconducteur, une couche semiconductrice faiblement dopée de type N dont la surface supérieure comporte au moins une région fortement dopée de type P délimitée par une zone d'isolement, comportant une étape de formation d'une couche métallique enterrée immédiatement sous la couche semiconductrice et d'au moins un contact métallique vertical s'étendant dans la couche semiconductrice jusqu'à la couche métallique, le contact atteignant la surface de la couche semiconductrice en dehors de la région.

Selon un mode de réalisation de la présente invention, l'étape de formation de la couche et du contact métallique comporte les étapes suivantes :
ouvrir dans la couche semiconductrice, en dehors de la région, au moins un puits vertical jusqu'à atteindre une couche enterrée intermédiaire entre le substrat et la couche semiconductrice ;
retirer la couche intermédiaire ; et
déposer un matériau métallique de façon à remplir l'évidement résultant du retrait de la couche enterrée ainsi que le puits vertical.

Selon un mode de réalisation de la présente invention, l'étape de dépôt du matériau métallique de façon à remplir l'évidement et le puits vertical consiste à déposer de façon conforme un matériau métallique et à procéder à un polissage mécano-chimique.

Selon un mode de réalisation de la présente invention, l'étape de retrait de la couche intermédiaire est suivie d'une épitaxie sélective d'une couche mince semiconductrice très fortement conductrice sur les seules portions découvertes de la couche semiconductrice dans le puits et dans l'évidement.

Selon un mode de réalisation de la présente invention, la couche semiconductrice épitaxiée a une épaisseur inférieure à 10 nm.

Selon un mode de réalisation de la présente invention, la couche intermédiaire est une couche monocristalline de silicium-germanium comportant une proportion de germanium d'au moins 20 %.

Selon un mode de réalisation de la présente invention, la couche intermédiaire est une couche isolante gravable sélectivement par rapport au substrat et par rapport à la couche semiconductrice.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
les figures 1A à 1D illustrent, en vue en coupe partielle et schématique, différentes étapes de formation d'un condensateur connu ; et
les figures 2A à 2E illustrent, en vue en coupe partielle et schématique, différentes étapes d'un procédé de formation d'un condensateur selon la présente invention.

Par souci de clarté, les mêmes éléments ont été désignés par les mêmes références aux différentes figures et, de plus, comme cela est habituel dans la représentation des circuits intégrés, les diverses figures ne sont pas tracées à l'échelle.

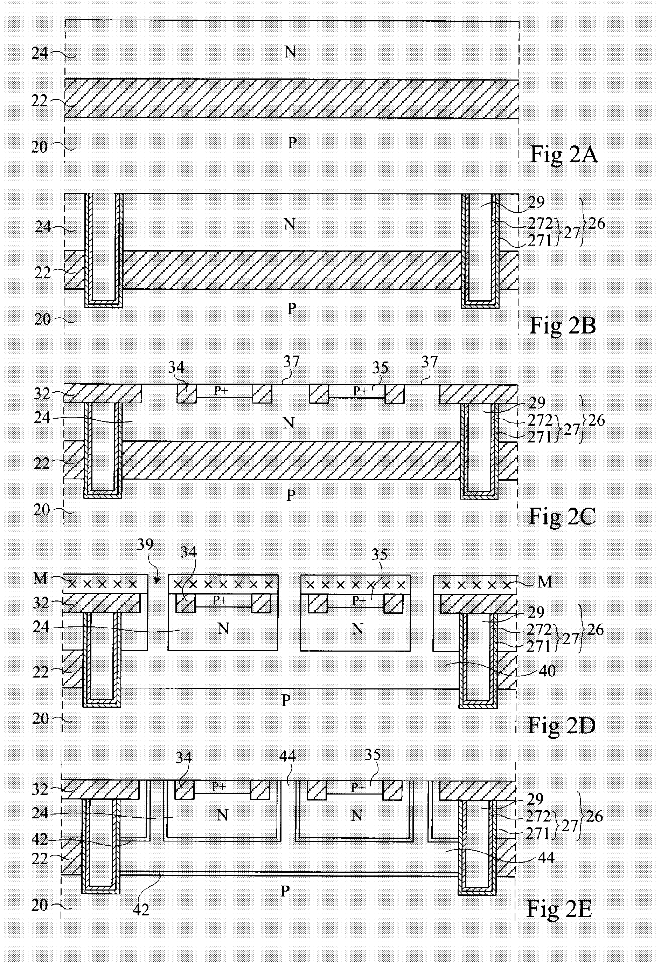

Comme l'illustre la figure 2A, le procédé selon l'invention part d'un substrat semiconducteur monocristallin 20, par exemple de silicium faiblement dopé de type P, recouvert de deux couches successives 22 et 24. La couche de surface (N) 24 est une couche semiconductrice monocristalline, par exemple de silicium faiblement dopé de type N. La couche intermédiaire 22 est en un quelconque matériau gravable sélectivement par rapport au substrat sous-jacent 20 et à la couche 24 superposée. Selon un mode de réalisation, la couche intermédiaire 22 est une couche isolante d'oxyde de silicium (SiO₂) . La couche 24 est alors du type silicium sur isolant. Selon un autre mode de réalisation, la couche 22 est une couche semiconductrice monocristalline de silicium-germanium comportant une proportion de germanium d'au moins 20 %.

Aux étapes suivantes illustrées en figure 2B, on forme dans l'empilement des couches 24 et 22 et dans une partie du substrat 20 sous-jacent une zone annulaire d'isolement profonde 26. La zone 26 est du type tranchée dont les parois verticales et le fond sont recouverts d'une couche isolante 27, la cavité restante étant comblée par une couche de remplissage par exemple de silicium polycristallin 29. De préférence, la couche isolante 27 est un multicouche constitué d'une couche inférieure 271 et d'une couche supérieure 272. La nature de la couche 27 ou de la couche inférieure 271 est choisie de façon que la couche 22 soit gravable sélectivement par rapport à celle-ci. Par exemple, lorsque la couche intermédiaire 22 est une couche d'oxyde de silicium, la couche inférieure 271 est une couche de nitrure de silicium et la couche supérieure 272 une couche d'oxyde de silicium. Dans la suite de la description, on ne considérera plus que les étapes mises en oeuvre dans la portion interne définie par la zone d'isolement profonde 26.

Ensuite, comme l'illustre la figure 2C, on forme des zones d'isolement peu profondes dans la seule couche de surface 24. Ainsi, on forme une zone d'isolement périphérique 32 qui s'étend de part et d'autre de la zone d'isolement profonde 26. On forme également des zones d'isolement 34 de faible dimension de façon à définir plusieurs régions distinctes à la surface de la couche 24. On forme, à la surface de la couche 24, par implantation/diffusion des régions (P⁺) 35 fortement dopées de type P. Chaque région 35 est délimitée par une zone 34. Une portion 37 de la couche 24 est maintenue entre deux zones 34 périphériques à des régions 35 distinctes. Une portion 37 est également maintenue entre la zone périphérique 32 et les zones d'isolement 34.

Aux étapes suivantes illustrées en figure 2D, on forme à l'aide d'un masque M dans les portions 37 de la couche 24 des puits 39 atteignant la surface supérieure de la couche intermédiaire 22. La couche 22 est alors éliminée par un procédé de gravure approprié. On forme ainsi immédiatement sous la couche 24 un évidement 40.

Ensuite, comme l'illustre la figure 2E, après retrait du masque M, on procède à une épitaxie de façon à faire croître une couche 42 très mince, de l'ordre de 5 à 10 nm, très fortement dopée de type N, avec une concentration de l'ordre de 10²¹ at./cm³. Ensuite, on dépose un matériau conducteur métallique 44, de façon à remplir l'évidement 40 et les puits 39. Pour ce faire on procède par exemple au dépôt d'une couche du matériau métallique 44 que l'on aplanit ensuite par polissage mécano-chimique (CMP). Le polissage CMP est complété, le cas échéant, par une gravure propre à retirer la couche 42 de la surface des régions d'anode 35. On notera que la couche 42 précédemment formée est nécessaire pour éviter la formation d'une jonction de type Schottky entre le matériau métallique 44 et la couche 24.

On obtient ainsi un condensateur constitué par la mise en parallèle de jonctions PN formées entre la couche de cathode commune 24 et les régions d'anode individuelles 35 dont la résistance d'accès à la cathode est avantageusement réduite. En effet, cette résistance d'accès est la résistance du contact métallique, la résistance de la couche mince 42 étant négligeable en raison d'une part de sa très faible épaisseur qui est limitée au strict minimum et de son dopage élevé. La résistance d'accès à la cathode est alors de l'ordre de 17 à 20 Ω.

On notera que le procédé de formation d'un condensateur selon la présente invention présente l'avantage de pouvoir partir directement d'un substrat de silicium sur isolant, comme cela a été indiqué précédemment. Cela est avantageux car le recours à de tels substrats est de plus en plus fréquent dans les filières technologiques actuelles. Un tel substrat est plus difficilement utilisable pour former un condensateur connu tel que décrit en relation avec les figures 1A-D, car il faudrait alors commencer par former successivement les couches 2 et 3. Selon la présente invention, il suffit de disposer de la couche 24 qui correspond à la couche 2 d'un condensateur connu.

Selon un mode de réalisation non représenté, la surface supérieure du substrat 20 des figures 2A à 2E initialement sous-jacente à la couche intermédiaire 22 est faiblement dopée de type N. Un tel dopage, compris par exemple entre 10¹² et 10¹⁴ at./cm³, permet d'améliorer l'isolement de la cathode 24-45 du condensateur et du substrat 20 par rapport à l'isolement obtenu par la seule couche 42.

Bien entendu, la présente invention est susceptible de diverses variantes et modifications qui apparaîtront à l'homme de l'art. En particulier, on a décrit à partir de la figure 2C les seules étapes mises en oeuvre dans la portion interne aux tranchées d'isolement profondes 26, portion dans laquelle le condensateur selon l'invention est formé. L'homme de l'art saura cependant mettre en oeuvre en-dehors de cette portion toute étape de procédé nécessaire à la formation d'autres éléments (commutateurs, transistors bipolaires, transistors MOS, inductances, résistances, etc...).

De plus, l'homme de l'art saura adapter le nombre et les dimensions en vue de dessus des puits 39 ainsi que les conditions de dépôt du matériau 44 qui sont choisies de façon à permettre un remplissage uniforme de l'évidement 40 entre le substrat 20 et la couche 24. Le nombre de puits 39 devra également être suffisamment limité pour garantir la cohésion de la couche 24 afin d'éviter sa chute dans l'évidement 40 après retrait de la couche intermédiaire sous-jacente 22. Cette chute est évitée par le fait que la couche 24 s'appuie contre la région annulaire d'isolement profonde 26.

De plus, on a considéré en relation avec la figure 2E que la couche 42 est formée de façon non sélective sur toutes les surfaces de silicium. Toutefois, pour diminuer les risques d'endommagement de la surface des anodes 35, on peut procéder également à une croissance sélective sur les seules surfaces du type N de la région 24 dans les puits 39 et l'évidement 40.

L'homme de l'art saura apporter toute modification de matériau et d'épaisseur nécessaire dans une filière technologique donnée. Ainsi, l'homme de l'art saura adapter les matériaux des zones d'isolement profondes 26. En particulier, l'homme de l'art adaptera le matériau isolant externe 27 ou 271 des zones 26 à la nature exacte de la couche intermédiaire 22 utilisée. Ainsi, lorsque la couche 22 est une couche d'oxyde de silicium, comme cela a été mentionné précédemment, il est indispensable que la couche 27 ou 271 soit en un matériau tel que du nitrure de silicium qui ne soit pas gravé lors du retrait (figure 2D) de la couche 22. Par contre, lorsque la couche 22 est en silicium-germanium, la couche 27 peut être réduite à la seule couche 272 d'oxyde de silicium.

De façon similaire, dans le cas d'une couche intermédiaire 22 en silicium-germanium, l'homme de l'art saura adapter sa concentration en germanium, de préférence supérieure à 20 %, aux contraintes d'élimination sélective de la couche 22 par rapport au substrat 20 sous-jacent et par rapport à la couche 24 superposée.

De même, l'homme de l'art saura adapter les matériaux conducteurs utilisés à la filière technologique utilisée. En particulier, l'homme de l'art adaptera le matériau métallique 44 aux contraintes de dépôt dans l'évidement 40 par les puits 39 et aux performances électriques recherchées. Le matériau conducteur 44 sera choisi dans le groupe des matériaux métalliques couramment utilisés pour une filière considérée. Dans le cas du silicium, le matériau 44 sera, par exemple, du cuivre, du tungstène, du titane, du nitrure de titane ou un alliage de ces métaux.

L'homme de l'art saura également adapter les épaisseurs et niveaux de dopage des diverses couches et/ou régions semiconductrices à des performances électriques recherchées. En particulier, l'homme de l'art saura ajuster le niveau de dopage de la cathode 24 du condensateur. Par exemple, après formation des zones d'isolement profondes 26 et/ou de surface 32 et/ou 34, on procédera à une implantation/diffusion de dopants de type N.

On notera qu'un condensateur selon la présente invention est susceptible de nombreuses applications. Par exemple, un tel condensateur peut être utilisé dans des architectures de récepteur multibande pour optimiser le fonctionnement de filtres du récepteur en fonction d'une application recherchée, par exemple une communication à fréquence élevée.

## Revendications

1. Condensateur réalisé dans une partie supérieure d'un substrat semiconducteur (20), comprenant au moins une couche semiconductrice (24) faiblement dopée de type N dont la surface supérieure comporte une région fortement dopée de type P (35) délimitée par une zone d'isolement (34), **caractérisé en ce qu'**un contact du condensateur est constitué d'une couche métallique (44) enterrée immédiatement sous la couche semiconductrice de type N et d'au moins un contact métallique vertical traversant la couche semiconductrice jusqu'à ladite couche métallique, ledit contact atteignant la surface de la couche semiconductrice en dehors de ladite région de type P.

2. Condensateur selon la revendication 1, dans lequel la couche métallique et le contact métallique sont constitués d'un même matériau métallique (44) choisi dans le groupe comprenant le tungstène, le nitrure de titane, le titane, le cuivre et des alliages de ces matériaux.

3. Procédé de formation d'un condensateur du type comprenant, dans une partie supérieure d'un substrat semiconducteur (20), une couche semiconductrice faiblement dopée de type N (24) dont la surface supérieure comporte au moins une région fortement dopée de type P (35) délimitée par une zone d'isolement (34), **caractérisé en ce qu'**il comporte une étape de formation d'une couche métallique enterrée immédiatement sous la couche semiconductrice et d'au moins un contact métallique vertical s'étendant dans la couche semiconductrice jusqu'à ladite couche métallique, ledit contact atteignant la surface de la couche semiconductrice en dehors de ladite région.

4. Procédé selon la revendication 3, dans lequel l'étape de formation de la couche et du contact métallique comporte les étapes suivantes :
ouvrir dans la couche semiconductrice (24), en dehors de la région (35), au moins un puits vertical (39) jusqu'à atteindre une couche enterrée (22) intermédiaire entre le substrat (20) et ladite couche semiconductrice ;
retirer la couche intermédiaire ; et
déposer un matériau métallique (44) de façon à remplir l'évidement (40) résultant du retrait de la couche enterrée ainsi que le puits vertical.

5. Procédé selon la revendication 4, dans lequel l'étape de dépôt du matériau métallique (44) de façon à remplir l'évidement (40) et le puits vertical (39) consiste à déposer de façon conforme un matériau métallique et à procéder à un polissage mécano-chimique.

6. Procédé selon la revendication 4 ou 5, dans lequel l'étape de retrait de la couche intermédiaire (22) est suivie d'une épitaxie sélective d'une couche mince semiconductrice très fortement conductrice (42) sur les seules portions découvertes de la couche semiconductrice (24) dans le puits (39) et dans l'évidement (40) .

7. Procédé selon la revendication 6, dans lequel la couche semiconductrice épitaxiée (42) a une épaisseur inférieure à 10 nm.

8. Procédé selon l'une quelconque des revendications 4 à 7, dans lequel la couche intermédiaire (22) est une couche monocristalline de silicium-germanium comportant une proportion de germanium d'au moins 20 %.

9. Procédé selon l'une quelconque des revendications 4 à 7, dans lequel la couche intermédiaire (22) est une couche isolante gravable sélectivement par rapport au substrat (20) et par rapport à la couche semiconductrice (24).
